# EUROPEAN PATENT SPECIFICATION

(11) **EP 1 960 192 B1**
(45) Date of publication and mention of the grant of the patent: **14.03.2018**
(21) Application number: 06839115.0
(22) Date of filing: 06.12.2006
(51) Int. Cl.: B32B 17/10

(54) **LAMINATES FOR HIGH SPEED AND HIGH FREQUENCY PRINTED CIRCUIT BOARDS**
LAMINATE FÜR HOCHGESCHWINDIGKEITS- UND HOCHFREQUENZ-LEITERPLATTEN
STRATIFIES POUR DES CARTES DE CIRCUIT IMPRIME A HAUTE VITESSE ET HAUTE FREQUENCE

(30) Priority: 06.12.2005 US 742857 P
(43) Date of publication of application: 27.08.2008
(73) Proprietor: Isola USA Corp., Chandler AZ 85226 (US)
(72) Inventor: AMLA, Tarun, Chandler, AZ 85248 (US); CONN, Peggy, M., Chandler, AZ 85226 (US); KAMLA, Jeff, Chandler, AZ 85226 (US)
(74) Representative: Müller-Boré & Partner Patentanwälte PartG mbB
(86) International application number: PCT/US2006/046598
(87) International publication number: WO 2007/067649

(56) References cited:
- EP-A2- 0 158 343
- WO-A-2005/004560

## Description

The invention relates to resin coated low profile copper sheets and to laminates made from them and methods for their manufacture. The sheets and laminates are useful in high speed and high frequency printed circuit boards.

For high speed and high frequency signal propagation in printed circuit boards it is advantageous to have low attenuation for better signal integrity. Signal attenuation is comprised of dielectric attenuation and conductor attenuation or loss. Conductor loss is a function of the type of conductor, its surface roughness and frequency of operation. As frequencies or data rates rise, the current flows in the skin of the conductor. At very high frequencies the conductor surface roughness becomes a major factor in increasing the resistivity of the conductor and causing increasing dielectric losses due to the additional traverse caused by surface undulations.

While low profile copper or other conductors would deliver lower loss, it is a challenge in the art to make low profile copper adhere with sufficient strength to the base material such as a prepreg in order to meet laminate peel strength requirements. Lower peel strength or lack of adhesion leads to constraints, such as line widths, etc., and it also adversely affects the functionality of the boards. Most of the current low dielectric loss laminates exhibit undesirable low peel strength due to the nature of the materials used; and although these products exhibit good dielectric loss properties, they show higher overall attenuation loss due to the use of rougher conductor to enhance adhesion to the substrate surface.

The invention provides a method for preparing laminates for use in the manufacture of printed circuit boards, as defined in claim 1.

The invention also provides a laminate as defined in claim 11, prepared by the methods described herein.

The invention further provides printed circuit boards comprising one or more laminates as described herein.

The invention further provides resin coated low profile copper sheets as defined in claim 8, prepared according to the methods described herein.

One aspect of this invention is a method for preparing a laminate for use in the manufacture of printed circuit boards. The method includes; providing a sheet of low profile copper foil having a first side and a second side, wherein at least one side of said low profile copper foil has a surface roughness of from 0.25 to 3.5 microns; applying a layer of low dielectric loss resin to one side of the low profile copper foil sheet; partially curing the layer of low dielectric loss resin to form a resin coated low profile copper sheet having a partially cured resin surface and a copper surface; and laminating the resin surface of the resin coated low profile copper sheet to a resin sheet to form a laminate having a copper surface.

Yet another aspect of this invention is a resin coated low profile copper sheet obtained by the above method comprising: a layer of low profile copper; and a layer of low dielectric loss resin.

Still another aspect of this invention are laminates obtained by the above method comprising one or more resin sheets as defined above; and at least one resin coated low profile copper sheet as defined above laminated together with the one or more resin sheets wherein the resin coated low profile copper sheet further comprises a layer of low profile copper having at least one side with a roughness of from about 0.5 to about 3.5 microns and a layer of low dielectric loss resin applied to the at least one side of the low profile copper sheet having a roughness of from about 0.5 to about 3.5 microns.
Figure 1 is a cross section view of a portion of a copper clad laminate prepared with a low profile copper wherein at least some of the teeth of the low profile copper foil surface abut a woven glass fiber laminate core; and
Figure 2 is a schematic showing B-staged resin coated low profile copper sheets and copper clad laminates of this invention in a general process flow scheme representing a method for their manufacture and Figure 2A is a cross section of a portion of the laminate product.

The invention provides a method for preparing laminates for use in the manufacture of printed circuit boards that are well suited for high speed and high frequency printed circuit board applications that require low dielectric loss.

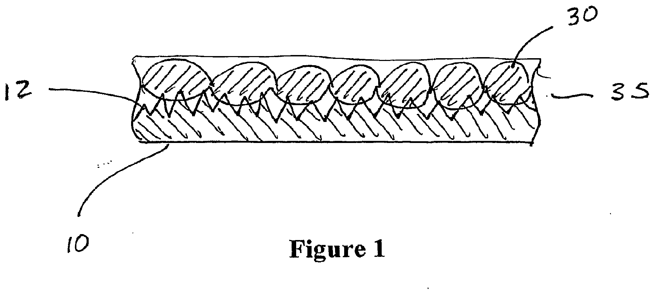

The laminates and printed circuit boards prepared according to the invention utilize low profile copper and exhibit low conductor loss and good signal integrity with enhanced peel strength. In particular, the invention includes B-staged resin coated low profile copper sheets as well as copper clad laminates prepared by laminating B-staged resin coated low profile copper sheets to prepregs. The copper clad laminates of this invention have improved peel strengths in comparison to laminates made by bonding low profile copper foil directly to prepreg. The higher peel strength is due to a better bond and better Hi pot resistance as the copper tooth profile is embedded in the B-staged resin and, as a result, does not directly contact the prepreg core material (usually a woven fiberglass cloth) which typically has a lower dielectric strength as compared to the resin. This is in contrast to the laminate of Figure 1 and the prior art where the teeth 12 of a low profile copper film layer 10 protrude into the woven fiberglass core 30 of a copper clad laminate 35. In contrast, the copper clad laminates of the present invention can withstand higher voltages across the laminate z-direction and they possess higher dielectric strength. Overall copper clad laminate dielectric properties are also enhanced by using low loss and low Dk resin systems.

The dielectric properties of the copper clad laminate are a function of volume and the B-staged low profile resin coated copper sheet can be used as a vehicle for adjusting the dielectric constant and dissipation factor of the resulting copper clad
laminate. As an example, a 76.2 µm (3.0 mil) laminate with a dielectric constant (DK) of 4.0 and a dielectric loss of 0.20 can be upgraded to a 127 µm (5.0 mil) laminate with a DK of about 3.4 and a dielectric loss of 0.013 by cladding 25.4 µm (1 mil) low profile copper foil with a resin having a DK at 2.5 and a dielectric loss of 0.002.

In one embodiment, this invention further includes a method of making a copper clad laminate. In the method, a low profile copper foil is coated with a resin to form a resin coated low profile copper sheet. The resin is the partially cured to form a B-staged resin coated low profile copper sheet. The B-staged sheet can be sold as is to laminate and printed wiring board manufactures or the B-staged sheet can laminated to prepreg to form a copper clad laminate.

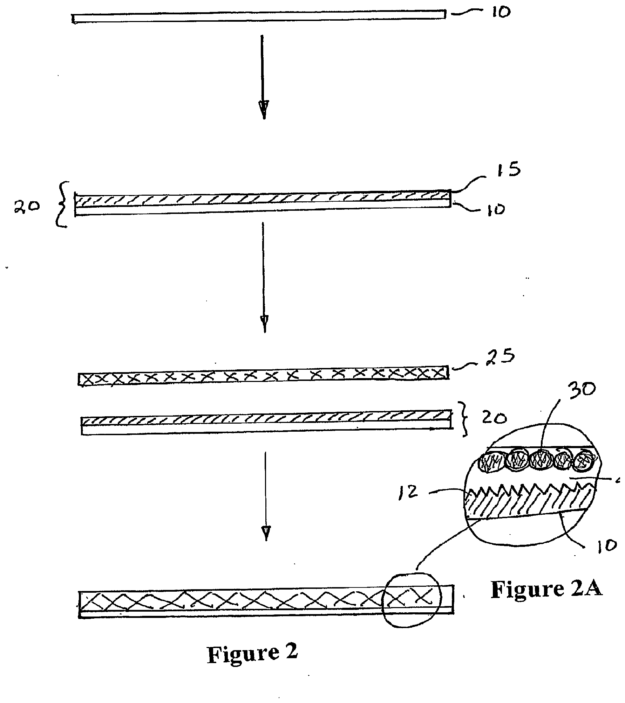

A schematic of this method is show in Figure 2. In Figure 2, a low profile copper foil 10 is provided. In the next step, a layer of low dielectric loss resin 15 and preferably a low loss and low Dk resin system is applied to a side of the low profile copper foil 10. The resin is then partially cured, for example by heating the resin, to form a B-staged resin coated low profile copper sheet 20. In the next step a resin sheet 25, preferably including a woven glass core is associated with the B-staged resin coated low profile copper sheet and in the final step, the resin sheet is laminated to the B-staged resin coated low profile copper sheet to form a laminate 35. A blown up view of a cross section of laminate 35 in Figure 2A shows that the low profile copper teeth 12 do not abut the woven glass fiber core 30 but are instead separated by a thin layer of resin 40. In the methods above, and in the laminates of this invention, the resin sheet can be either a prepreg or it can be a fully cured, C-staged resin containing laminate that is unclad. In the description below, reference to prepregs also refers generally to C-staged resin containing laminates.

The copper foil for use in the invention is a low profile copper foil material. The term "low profile copper foil as used herein refers to copper foils that have at least one rough surface having an average surface roughness less than about 4.0 microns and preferably having an average surface roughness of from about 0.25 to about 3.5 microns (as measured from valley to peak on the surface of the copper). In addition, the copper foils useful in the present invention will have a thickness of from about 2.0 microns to about 400 microns and preferably thicknesses of from about 10 to about 70 microns. The at least on rough surface is the surface to which the resin is applied to form a B-staged resin coated low profile copper sheet. The outside surface of the copper foil may be rough or smooth depending upon the application requirements. Low profile copper foils are manufactured by, for example from Circuit Foil, Luxembourg.

It should be noted that generally any conductive material that is capable of being applied to a resin or
manufactured in foil form that meets the physical specifications identified for low profile copper foils above may be used.

The coating of the low profile copper foil with an uncured or partially cured resin is preferably done using RCC (resin coated copper) techniques known in the industry. In one method, a low profile copper foil is provided in a roll and the copper foil is coated using doctor rolls or slot dies and the foil sheet is thereafter directed into an oven where the applied resin is cured to a B-stage. Of course other processes may be used to apply a resin to a surface of the low profile copper foil such as, for instance, spray coating. Following coating, the resin lay of the resin coated low profile copper sheet is partially cured. Alternatively, the resin may be partially cured before coating on the copper and the sheet used as is or the resin can be cured further before the sheet is used.

The thickness of the partially cured resin on the copper foil is preferably between about 2 microns and about 400 microns. More preferably, the resin coated copper has a thickness of from about 5 to about 150 microns. In any event, the resin coating should have a thickness that is sufficient to fill the valleys in the copper surface and to cover the copper surface peaks as well.

An alternative procedure for forming resin coated low profile copper is to prepare a partially cured resin sheet and then deposit copper onto the partially cured resin sheet in a manner that causes a low profile copper to form on the resin sheet. Useful deposition techniques include, for instance, direct sputtering of copper on the partially cured resin sheet. In this case, up to about 2 micron of copper is deposited on the partially cured resin sheet.

The resin coated low profile copper sheet consists essentially of a partially cured resin layer associated with a low profile copper layer or foils sheet such that one face of the sheet is copper and one face of the sheet is resin. An optional partially cured neat resin film layer may be located between the B-staged resin coated low profile copper sheet and the prepreg to facilitate adhesion of the two sheets.

The resin used in the resin coated low profile copper sheet and optionally in the prepregs to which the sheets are laminated are low loss dielectric resin materials or materials that are chemically compatible (e.g., forms acceptable bond strength) with low dielectric loss resins. Preferred low loss materials include those described in U.S. Patent No. 7,090,924 and in published U.S. patent application no. US 2003-0158337 A1, the disclosures of each of which are incorporated herein by reference in their entirety. Particularly preferred resins are those found in the '924 patent.

The resins useful for manufacturing the prepregs discussed above is generally the same resins that is useful as the low dielectric loss material that is applied to or to which a low profile copper layer is applied. One example of a useful class of resins is thermosetting resin compositions comprising at least one elastomer; at least one ester; and at least one flame retardant. Two specific examples of low dielectric loss resin systems are discussed below.

In the first example, the elastomer used in the resin composition provides the desired basic mechanical and thermal properties of the cured resin and laminates made there from. Suitable elastomers are any elastomers that are known to one of skill in the art to be useable in electronic composites and laminates. Preferably, the elastomer has a molecular weight in the range of about 2000 to about 20000. The elastomer can be used alone or in combination with other elastomer(s). Examples of useful elastomers include, but are not limited to, butadiene polymers, styrene butadiene polymers, acrylonitrile-butadiene copolymers, isoprene polymers, urethane elastomers, polyamides, and thermoplastic polymers in general, or mixtures thereof. One useful class of elastomers are styrene butadiene divinyl benzene compounds (SBDVB). SBDVD compounds include many unsaturated groups which allow them to crosslink with other resin compounds during resin curing. An example of an SBDVB compound is Ricon® 250, a polybutadiene styrene divinylbenzene graft terpolymer available from Sartomer (502 Thomas Jones Way, Exton, PA 19341). Another useful elastomer is a maleinized polybutadiene styrene copolymer. An example of a maleinized polybutadiene styrene copolymer is Ricon® 184MA6, available from Sartomer. Elastomers are present in the thermosetting resin compositions of the invention in an amount from about 20 % to about 60 %, preferably from about 25 to about 35 %, based on 100 % by weight resin solids of the composition.

The esters are used in the first exemplary resin composition to, in most instances, improve thermal and electrical properties of the resulting cured polymer and products made there from by reacting with unreacted elastomer ingredients and by-products. The esters react with and consume excess styrene in the elastomers. The esters can be monomers, oligomers or polymers, such as polyesters. Preferably, the ester is an unsaturated ester. Also preferably the ester is styrenic based. A preferred ester is an acrylic ester such as, but not limited to, dipentaerythritol pentaacrylate. Another preferred ester is an unsaturated polyester. A preferred unsaturated polyester is the condensation reaction product of an unsaturated acid or anhydride, such as maleic anhydride or fumaric acid, or an aromatic acid, with a linear diol(s). The product of this condensation reaction preferably has the following properties: about 0 % free styrene content; average molecular weight of 4000-7000; and an acid value of 12-18. Esters may be present in the thermosetting resin compositions of the invention in an amount of from about 1 % to about 15 %, preferably from about 2 to about 8 %, more preferably from about 2 % to about 6 %, based on 100 % by weight resin solids of the composition.

The first thermosetting resin composition example may also include one or more flame retardants. Any flame retardant that is known to be useful in resin compositions used to manufacture composites and laminates may be used. Examples of useable flame retardants include, but are not limited to, halides of glycidyl etherified bifunctional alcohols, halides of novolac resins such as bisphenol A, bisphenol F, polyvinylphenol or phenol, creosol, alkylphenol, catecohl, and novolac resins such as bisphenol F, inorganic flame retardants such as antimony trioxide, red phosphorus, zirconium hydroxide, barium metaborate, aluminum hydroxide, and magnesium hydroxide, and phosphor flame retardants such as tetraphenyl phosphine, tricresyl-diphenyl phosphate, triethylphosphate, cresyldiphenylphosphate, xylenyl-diphenyl phosphate, acid phosphate esters, phosphate compounds containing nitrogen, and phosphate esters containing halides. Flame retardants may be present in the first thermosetting resin compositions in an amount of from about 5 to about 50 %, preferably from about 10 to about 40 %, based on 100 % by weight resin solids of the composition.

One preferred flame retardant is decabromodiphenylethane, which has the following structure: 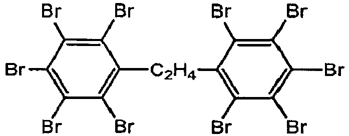 Decabromodiphenylethane is commercially available, for example, from Albemarle Corporation (451 Florida St., Baton Rouge, LA 70801). The Albemarle product is sold as Saytex™ 8010. Decabromodiphenylethane is easily dispersed in the resin composition. Decabromodiphenylethane also significantly improves dielectric properties of the cured resin. As a result, the flame retardant is included in the resin compositions in amounts far greater than is necessary for a flame retardant in order to also enhance the dielectric properties of the cured resin. When decabromodiphenylethane is used as the flame retardant, it is preferably present in the thermosetting resin compositions in an amount of from about 10 % to about 50 %, more preferably from about 20 % to about 45 %, based on 100 % by weight resin solids of the composition.

One or more catalysts are optionally added to the first thermosetting resin compositions in order to enhance the rate of resin cure. The catalysts chosen may be any catalysts that are know to speed up the rate of thermosetting resin cure. Preferred catalysts include peroxide catalysts that generate free radicals such as dicumyl peroxide, or tert-butyl peroxybenzoate (commercially available from, for example, Akzo-Nobel Polymer Chemicals LLC, Chicago, IL as Triganox-C). A more preferred catalyst is dicumyl peroxide. Catalysts are present in the thermosetting resin compositions of the invention preferably in an amount of from about 2 % to about 8 %, more preferably from about 3 % to about 5 %, based on 100 % by weight resin solids of the composition.

One or more fillers can optionally be added to the first thermosetting resin compositions to improve chemical and electrical properties of the cured resin. Examples of properties that can be modified with fillers include, but are not limited to, coefficient of thermal expansion, lowering CTE, increasing modulus, and reducing prepreg tack. Non-limiting examples of useful fillers include particulate forms of Teflon®, talc, quartz, ceramics, particulate metal oxides such as silica, titanium dioxide, alumina, ceria, clay, boron nitride, wollastonite, and mixtures thereof. Preferred fillers include calcined clay or fused silica. Another preferred filler is fused silica. Yet another preferred filler is silane treated silica. More preferably, the silane treated filler is fused silica treated with epoxy silane. When used, fillers may be present in the thermosetting resin compositions of the invention in an amount of from about 0 % to about 40 %, preferably from about 5 to about 40 %, based on 100 % by weight resin solids of the composition. Preferably the particle size of the filler is about 20 µm to about 80 µm.

One or more solvents are optionally incorporated into the first thermosetting resins in order to control resin viscosity and in order to maintain the resin ingredients in a suspended dispersion. Any solvent known by one of skill in the art to be useful in conjunction with thermosetting resin systems can be used. Particularly useful solvents include methylethylketone (MEK), toluene, and mixtures thereof. The choice of solvent is often dictated by the resin curing method. When the resin is cured with hot air, then ketones are typically the preferred solvent. When the resins are 1R cured, then a mixture of ketones and toluene is typically preferred. When used, solvents are present in the thermosetting resin compositions of the invention in an amount of from about 20 % to about 50 % as a weight percentage of the total weight of the composition.

The first exemplary resin system can optionally include cyanate esters, which can improve thermal performance and provide good electrical properties. Cyanate esters can participate in the polymerization and incorporate into the resin backbone. Various cyanate esters can be used, including, but not limited to 2,2-Bis(4-cyanatophenyl)isopropylidene (available from Lonza Group under the name Primaset® BADCy), bisphenol A cyanate ester (available from Ciba Geigy under the name AroCy™ B10), and mixtures thereof. When used, the cyanate ester(s) are present in the thermosetting resin compositions in an amount about 2 % to about 15 %, preferably from about 4 to about 8 %, based on 100 % by weight resin solids of the composition.

One useful first resin system has the following formulation, wherein amounts are based on 100 % by weight resin solids of the composition.
from about 25 to about 35 wt % of at least one elastomer;
from about 2 to about 8 wt % of at least one ester;
from about 20 to about 45 wt % of at least one flame retardant;
from about 5 to about 40 wt % of at least one filler; and
from about 3 to about 5 wt % of at least one catalyst. The ingredients are suspended in a solvent in a ratio ranging from about 50-80 wt% solids to 50-20 wt% solvent and preferably about 70 wt% solids to about 30 wt% solvent.

Other useful first resin compositions have the following formulations:

| ***FIRST EXEMPLARY HIGH PERFOMANCE RESIN FORMULATION*** | | |
|---|---|---|
| **Ingredients** | **Range (wt%)** | **Preferred Amounts(wt%)** |
| Styrene-Butadiene-Divinylbenzene terpolymer from Sartomer (Elastomer) | 20 - 60 | 25-30 |
| An unsaturated Polyester | 2-15 | 5-7 |
| Decabromodiphenylethane | 10-50 | 30-40 |
| Calcined Clay or Fused Silica (filler) | 20 - 40 | 23-28 |
| Dicumyl peroxide (catalyst) | 2 - 5 | 4 |

The ingredients are preferably suspended in a solvent such as toluene, MEK or toluene/ MEK in a ratio ranging from about 50-80 wt % solids to 50-20 wt % solvent and preferably about 70 wt % solids to about 30 wt % solvent.

Yet other useful first resin compositions have the following formulation, based on 100 % by weight resin solids of the composition.:
from about 30 to about 35 wt % of RICON® 250 resin;
from about 2 to about 4 wt % of an unsaturated polyester;
from about 20 to about 25 wt % of decabromodiphenylethane;
from about 32 to about 38 wt % of fused silica; and
from about 5 to about 6 wt % of dicumyl peroxide.

A second exemplary high performance resin composition comprises: (1) at least one epoxy resin; (2) at least one styrene maleic anhydride; and (3) a bis-maleimidetriazine resin. The composition optionally includes one or more of the following: (4) a filler; (5) a toughener; (6) an accelerator; (7) a flame retardant; (8) a solvent; and/or (9) other additives. The ingredients optional and otherwise of the second exemplary resin system.

### (1) The Epoxy Resin

The term "epoxy resin" in this context refers to a curable composition of oxirane ring-containing compounds as described in C.A. May, Epoxy Resins, 2nd Edition, (New York & Basle: Marcel Dekker Inc.), 1988.

The epoxy resin is added to the resin composition in order to provide the desired basic mechanical and thermal properties of the cured resin and laminates made there from. Useful epoxy resins are those that are known to one of skill in the art to be useful in resin compositions useful for electronic composites and laminates.

Examples of epoxy resins include phenol types such as those based on the diglycidyl ether of bisphenol A ("Bis-A epoxy resin"), on polyglycidyl ethers of phenolformaldehyde novolac or cresol-formaldehyde novolac, on the triglycidyl ether of tris(p-hydroxyphenol)methane, or on the tetraglycidyl ether of tetraphenylethane, or types such as those based on tetraglycidylmethylenedianiline or on the triglycidyl ether of p-aminoglycol; cycloaliphatic types such as those based on 3,4-epoxycyclohexylmethyl-3,4-epoxycyclohexane carboxylate. The term "epoxy resin" also includes within its scope reaction products of compounds containing an excess of epoxy (for instance, of the aforementioned types) and aromatic dihydroxy compounds. These compounds may be halogen substituted.

Preference is given to epoxy resins which are derivatives of bisphenol A ("Bis-A epoxy resin"), particularly FR4. FR4 is made by an advancing reaction of an excess of bisphenol A diglydicyl ether with tetrabromobisphenol A. Mixtures of epoxy resins with bismaleimide resin, cyanate resin and/or bismaleimide triazine resin can also be used.

It should be noted that epoxy resins are generally represented by a single, unequivocal structural formula. The skilled person will know that this should be taken to include deviating products resulting from side reactions occurring during epoxy resin preparation. As these side products constitute a normal component of cured epoxy resins, they likewise constitute a normal component of the resins according to this invention. Epoxy resins are present in the composition of this invention in an amount from about 8 % to about 26 %, and preferably from about 10 to about 23 %, based on 100 % by weight solids of the composition.

Bisphenol A (BPA) and/or bisphenol A diglycidyl ether (BPADGE) can optionally be included with the epoxy resin as co-crosslinking agents. Both the BPA and the BPADGE may optionally be brominated, i.e. substituted with one or more bromine atoms. Resin systems incorporating optionally brominated bisphenol A and optionally brominated bisphenol A diglycidyl ether that are useful in the present invention are described in U.S. Patent No. 6,509,414. The specification of which is incorporated herein by reference in its entirety. In the present invention, the aromatic moieties of BPA and BPADGE are preferably substituted with two bromine atoms, to give tetrabromobisphenol A (TBBA) and tetrabromobisphenol A diglycidyl ether (TBBADGE), respectively. Optionally brominated novolacs can also be used as co-cross-linking agent. Brominated co-crosslinking agents are preferred because of their flame retarding properties.

The desired resin properties determine the amount of optionally brominated BPA and optionally brominated BPADGE to be incorporated into the resin. For instance, it has been found that the Tg of epoxy resins cross-linked with SMA can be increased substantially by the use of at least 5% by weight of BPA. It is now possible, as indicated above, to obtain resins having glass transition temperatures of 130°C and higher even with simple difunctional epoxy compounds. When a co-crosslinking agent is used, it is generally present in amount of about 5 % to about 60 %, preferably about 15 % to about 55 %, based on 100 % by weight solids of the composition. In a preferred embodiment, the resin composition contains both TBBA and TBBADGE. In this preferred embodiment, the TBBA is present in an amount of from about 3 % to about 21 wt %, preferably from about 6 % to about 19 %, and the TBBADGE is present in amount of from about 9 wt % to about 30 wt %, preferably from about 11 wt % to about 26 wt %, each based on 100 % by weight solids of the composition.

### 2) Styrene Maleic Anhydride Copolymer

The second thermosetting resin compositions include one or more styrene maleic anhydride compounds (SMA). SMA improves the thermal and electrical properties of the resulting cured polymer and products made there from by reacting with unreacted elastomer ingredients and by-products.

Copolymers of styrene and maleic anhydride have been described, inter alia, in Encyclopedia of Polymer Science and Engineering Vol. 9 (1987), page 225. Within the framework of this invention the term "copolymer" likewise refers to SMA or mixtures of SMA. Copolymers of styrene and maleic anhydrides (SMA) are commercially available in two types. Type 2 comprises mostly high-molecular weight copolymers (MW generally higher than 100,000, for instance, 1,000,000). These are in fact thermoplastics, which are unsuitable for use in the manufacture of prepregs. Moreover, because of their low anhydride content (5-15%) they are not particularly suitable for use as a crosslinking agent for epoxy resin either. The type 1 SMA copolymers, on the other hand, which have a molecular weight in the range of about 1400 to about 50,000 and an anhydride content of more than 15 % by weight, are especially suited for use in compositions of this invention. Preference is also given to SMA copolymers having a molecular weight in the range of 1400 to 10,000. Examples of such copolymers include the commercially available SMA 1000, SMA 2000, SMA 3000, and SMA 4000. These copolymers have a styrene maleic anhydride ratio of 1:1. 2:1, 3.1, and 4:1, respectively, and a molecular weight ranging from about 1400 to about 2000. Mixtures of these SMAs may also be used. SMA polymers are present in the thermosetting resin compositions of this invention in an amount from about 10 % to about 26 %, preferably from about 15 to about 23 %, based on 100 % by weight solids of the composition. In one embodiment, the amount of epoxy resin exceeds the amount of SMA in order to provide an excess of functionality of the epoxy over the SMA. In this embodiment, the weight ratio of epoxy resin to SMA copolymer is preferably about 2:1 to about 1.5:1 (epoxy:SMA).

### (3) Bis-maleimidetriazine resins

The second thermosetting resin compositions further includes a Bis-maleimidetriazine resin (BT). BT resins are commercially available from Mitsubishi. Bis-maleimidetriazine resins are present in the thermosetting resin compositions of this invention in an amount from about 15 % to about 50 %, preferably from about 25 to about 40 %, based on 100 % by weight solids of the composition.

### (4) The Optional Filler

One or more fillers can optionally be added to the second resin compositions to improve chemical and electrical properties of the cured resin. Examples of properties that can be modified with fillers include, but are not limited to, coefficient of thermal expansion, lowering CTE, increasing modulus, and reducing prepreg tack. Non-limiting examples of useful fillers include particulate forms of Teflon®, talc, quartz, ceramics, particulate metal oxides such as silica, titanium dioxide, alumina, ceria, clay, boron nitride, wollastonite, and mixtures thereof. Preferred fillers include calcined clay or fused silica. Another preferred filler is fused silica. Yet another preferred filler is silane treated silica. More preferably, the silane treated filler is fused silica treated with epoxy silane. When used, fillers are present in the thermosetting resin compositions of this invention in an amount from about 0 % to about 20 %, preferably from about 0 to about 10 %, based on 100 % by weight solids of the composition.

### (5) The Optional Toughener

The second thermosetting resin compositions may include one or more toughners. The toughners are added to the resin compositions to improve the drillability of the resulting composites and laminates. Useful toughners include methyl methacrylate/butadiene/styrene copolymer, methacrylate butadiene styrene core shell particles, and mixtures thereof. A preferred toughener is methacrylate butadiene styrene core shell particles, which is available from Rohm & Haas (100 Independence Mall West, Philadelphia, PA), sold under the trade name Paraloid®. When used, tougheners are present in the thermosetting resin compositions of this invention in an amount from about 1 % to about 5 %, preferably from about 2 to about 4 %, based on 100 % by weight solids of the composition.

### (6) Accelerators

One or more accelerators are typically added to the second composition to crosslink the resins and to enhance the rate of resin cure. The accelerators chosen may be any accelerators that are know to speed up the rate of thermosetting resin cure. As suitable accelerators may be mentioned imidazoles, more particularly alkyl substituted imidazoles such as 2-methylimidazole and 2-ethyl-4-methylimidazole, 2-phenylimidazole, 2-phenyl, 4-methylimidazole. Other suitable accelerators include tertiary amines, e.g. benzyldimethylamine and 4,4' and 3,3' diaminodiphenylsulphone. One preferred accelerator is 2-ethyl-4-methylimidazole. The amount of accelerator used is dependent on the type of epoxy resin, the type of cross-linking agent, and the type of accelerator. Employing a too large amount of accelerator will lead to a too highly reactive resin system. The skilled person can easily determine the amount of accelerator needed to provide a resin system that is sufficiently reactive to allow ready processing into prepregs. In general, such amount will be between 0 01 and 5% by weight of accelerators, calculated on the overall weight of epoxy resin and co-crosslinking agent present in the composition. In many cases this will be the 0.01-0.05 % by weight range. The resin gel is dependent on the type anal amount of accelerator, the type and amount of solvent, and the type of prepreg to be manufactured. In the specific case of 2 methylimidazole (2MI) being used as a accelerator, it is preferred not to use more than about 0.05% by weight of 2MI. By way of general guideline it can be said that it is advisable not to have a varnish gel time of less than 120 seconds.

### (7) Optional Flame Retardants

The second thermosetting resin compositions may include one or more flame retardants. Any flame retardant that is known to be useful in resin compositions used to manufacture composites and laminates may be used. Examples of useable flame retardants include, but are not limited to, halides of glycidyl etherified bifunctional alcohols, halides of novolac resins such as bisphenol A, bisphenol F, polyvinylphenol or phenol, creosol, alkylphenol, catecohl, and novolac resins such as bisphenol F, inorganic flame retardants such as antimony trioxide, red phosphorus, zirconium hydroxide, barium metaborate, aluminum hydroxide, and magnesium hydroxide, and phosphor flame retardants such as tetraphenyl phosphine, tricresyl-diphenyl phosphate, triethylphosphate, cresyldiphenylphosphate, xylenyl-diphenyl phosphate, acid phosphate esters, phosphate compounds containing nitrogen, and phosphate esters containing halides. Flame retardants are present in the second thermosetting resin compositions in an amount of from about 3 to about 9 %, preferably from about 4 to about 8 %, based on 100 % by weight resin solids of the composition.

Another optional flame retardant is decabromodiphenylethane, which has the following structure: 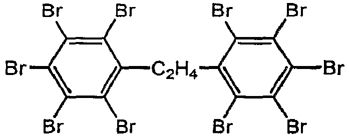 Decabromodiphenylethane is commercially available, for example, from Albemarle Corporation (451 Florida St., Baton Rouge, LA 70801). The Albemarle product is sold as Saytex™ 8010. Decabromodiphenylethane has been unexpectedly found to be easily dispersed in the resin composition. Decabromodiphenylethane also has the unexpected and synergistic result of significantly improving dielectric properties of the cured resin. As a result, the flame retardant can be included in the second resin composition in amounts far greater than is necessary for a flame retardant in order to also enhance the dielectric properties of the cured resin. When decabromodiphenylethane is used as the flame retardant, it is preferably present in the thermosetting resin compositions in an amount of from about 10 % to about 50 %, more preferably from about 20 % to about 45 %, based on 100 % by weight resin solids of the composition. When a brominated flame retardant is used, it is preferably present in an amount sufficient to provide a total bromine content to the composition of about 8 % to about 30 %, preferably about 10 to about 20 %, based on 100 % by weight solids of the composition.

### (8) Solvents

One or more solvents are typically incorporated into the second thermosetting resins in order to provide resin solubility, control resin viscosity, and in order to maintain the resin ingredients in a suspended dispersion. Any solvent known by one of skill in the art to be useful in conjunction with thermosetting resin systems can be used. Particularly useful solvents include methylethylketone (MEK), toluene, dimethylformamide (DMF), or mixtures thereof. The choice of solvent is often dictated by the resin curing method. When the resin is cured with hot air, then ketones are typically the preferred solvent. When the resins are IR cured, then a mixture of ketones and toluene is typically preferred. When used, solvents are present in the thermosetting resin compositions of this invention in an amount of from about 20 % to about 50 % as a weight percentage of the total weight of the composition.

Optionally, the second thermosetting resin composition may further contain other additives such as defoaming agents, leveling agents, dyes, and pigments. For example, a fluorescent dye can be added to the resin composition in a trace amount to cause a laminate prepared there from to fluoresce when exposed to UV light in a board shop's optical inspection equipment. A useful fluorescent dye is a highly conjugated diene dye. One example of such a dye is UVITEX® OB (2,5-thiophenediylbis(5-tert-butyl-1,3-benzoxazole), available from Ciba Specialty Chemicals, Tarrytown, New York.

One useful second composition has the following formulation:

| ***SECOND EXEPMLARY HIGH PERFORMANCE RESIN FORMULATION*** | | | |
|---|---|---|---|
| | **INGREDIENTS** | **Range(wt%)** | **Preferred Amounts(wt%)** |
| Epoxy Resin | | | |
| - Bis-A Epoxy Resin | 10-26 | 15-23 | |
| - Brominated Bis-A Epoxy (TBBADGE) | 9-30 | 13-26 | |
| - Tetrabromobisphenol A (TBBA) | 7-21 | 11-19 | |
| | | | |
| SMA | 10-26 | 15-23 | |
| Toughener | 1-5 | 2-4 | |
| Methacrylate butadiene styrene core shell particles (Paraloid 2591) | | | |
| Accelerator | 0.05-1.0 | 0.2-0.5 | |
| BT Resin | 15-50 | 25-40 | |
| Filler | 0-20 | 0-10 | |

The ingredients are suspended in a DMF, MEK or MEK/ DMF solvent in a ratio ranging from about 50-80 wt% solids to 50-20 wt% solvent and preferably about 70 wt% solids to about 30 wt% solvent.

In addition to the resin systems identified above, any resin system that is know to a person skilled in the art now or in the future that are useful in the preparation of a printed wiring board laminate and in particular, high speed and high frequency wiring board laminates may be used in the methods and products of this invention.

The resins used in this invention for making the prepreg or C-staged resin sheets and for making the resin coated low profile copper sheet may include optional fillers. The use of fillers allows for the tailoring of dielectric properties of the resulting copper clad laminate. Moreover, fillers can be used in one resin system and not the other and still be useful in controlling dielectric properties of the resulting copper clad laminate.

The prepreg or C-staged resin sheets may include an optional core. Any core materials used in low dielectric loss laminates may be used. It is preferred that, if a core material is used, then it is a woven glass fiber.

The next step in the process of the invention is the lamination of the resin coated low profile copper with a prepreg. Prepregs are generally manufactured using a core material such as a roll of woven glass web which is unwound into a series of drive rolls. The web then passes into a coating area where the web is passed through a tank which contains a thermosetting resin composition, solvents and other components. The glass web becomes saturated with the resin in the coating area. The resin saturated glass web is then passed through a pair of metering rolls which remove excess resin from the resin saturated glass web and thereafter, the resin coated web travels the length of a drying tower for a selected period of time until the solvent is at least partially evaporated from the web. Second and subsequent coatings of resin can be applied to the web by repeating these steps until the preparation of the prepreg is complete whereupon the prepreg is wound onto roll.

Lamination processes useful in the present invention typically entail a stack-up of one or more prepreg layers between one or two sheets of the resin coated low profile copper of the invention. Thus, if two sheets of resin coated low profile copper are used, the prepreg layer will lie between the two resin coated low profile copper sheets such that the copper layers lie on the outside surfaces of the resulting laminate sheet.

In one example of a cure cycle, the stack is maintained at a pressure of about 275 kPa (about 40 psi) to about 6200 kPa (about 900 psi) and under a vacuum of about 100 kPa (about 30 in/Hg). The stack temperature is raised from about 82 °C (about 180 °F) to about 190 to 230 °C (about 375 °F to 450 °F) over a period of about 20-60 minutes. The stack remains at a temperature of about 190 to 230 °C (about 375 °F-450 °F) for 75-180 minutes after which the stack is cooled from a temperature of 190 to 230 °C (375 °F-450 °F) to a temperature of about 24 °C (about 75 °F) over a 20 -50 minute period.

In another process for manufacturing laminates, suitable resins are premixed in a mixing vessel under ambient temperature and pressure. The viscosity of the pre-mix is about 0.6-1 Pa·s (about 600-1000 cps) and can be adjusted by adding or removing solvent from the resin. A fabric substrate, such as E glass, is pulled through a dip tank including the premixed resin, through an oven tower where excess solvent is driven off and the prepreg is rolled or sheeted to size and layed up between resin coated high profile copper sheets in various constructions depending on glass weave style, resin content & thickness requirements.

In a further example of a process for manufacturing laminates, a resin coating that is compatible to the resin coating the high profile copper is first coated on a prepreg or C-staged laminate and optionally partially cured. The resin coated low profile copper is then laminated with the coated prepreg or C-staged laminate and processed as described above. Compatible resins are generally resins that facilitate to lamination of the two sheets. Preferred compatible resins are preferably low loss materials that adhere well with the resin on the copper. Particularly preferred is to use the same resin on the copper and on the prepreg or laminate.

As noted above, the invention also provides laminates for use in printed circuit boards obtained by the above-defined method. A laminate of the invention comprises:
one or more resin sheets as defined above; and at least one resin coated low profile copper sheet as defined above, wherein the at least one resin coated low profile copper sheet is laminated together with the one or more resin sheets, wherein the resin coated low profile copper sheet further comprises a layer of low profile copper having at least one side with a roughness of from about 0.5 to about 3.5 microns and a layer of low dielectric loss resin applied to the at least one side of the low profile copper sheet having a roughness of from about 0.5 to about 3.5 microns.

The invention further provides printed circuit boards comprising one or more laminates as described in the preceding paragraph.

The invention further provides resin coated low profile copper sheets obtainable by the above-defined method.

### EXAMPLE

The following hypothetical example is illustrative of the invention, but is not intended to limit its scope.

Low profile copper is coated in a standard RCC process with a resin composition comprising the ingredients shown in Table 1. Toluene is used as a solvent.

**Table 1.**

| **Material** | **Amount (percentage of 100 % solids)** |
|---|---|
| Ricon® 250 (a styrene butadiene divinyl benzene elastomer) | 50 % |
| an unsaturated polyester | 5 % |
| Decabromodiphenylethane flame retardant | 36 % |
| Dicumyl peroxide catalyst | 9 % |

The resin is coated to provide a thickness of about 200 microns (following partial cure). As part of the RCC coating process, the resin on the copper is partially cured.

A laminate is prepared using the resin composition shown in Table 2. Toluene is used as solvent to provide a total solids content of about 69 %.

**Table 2.**

| **Material** | **Amount (percentage of 100 % solids)** |
|---|---|
| Ricon® 250 | 32 % |
| an unsaturated polyester | 3 % |
| Decabromodiphenylethane flame retardant | 23 % |
| Fused silica filler | 36 % |
| Dicumyl peroxide catalyst | 6 % |

Thus, a prepreg is first prepared using 0.7 mm (0.03") woven glass fabric and the composition in Table 2. The resin in the prepreg is partially cured.

A laminate is then prepared by the stacking-up of one or more prepreg layers between one or more sheets of resin coated low profile copper. For the cure cycle, the stack is maintained at a pressure of about 275 kPa (about 40 psi) to about 6200 kPa (about 900 psi) and under a vacuum of about 100 kPa (about 30 in/Hg). The stack temperature is raised from about 82 °C to about 190 °C (about 180 °F to about 375 °F) over a period of about 20 minutes. The stack remains at a temperature of about 190 °C (about 375 °F) for 75 minutes after which the stack is cooled to 24 °C (75 °F) over a 20 minute period.

The low profile copper layer peel strength of the laminate made above will be about 0.79 to about 0.875 N/mm (about 4.5 to about 5 lbs/in). This compares to an expected peel strength of about 0.35 N/mm (about 2 lbs/in) when the low profile copper foil is laminated directed to a prepreg.

## Claims

1. A method for preparing a laminate for use in the manufacture of printed circuit boards, the method comprising:
providing a sheet of low profile copper foil having a first side and a second side, wherein at least one side of said low profile copper foil has a surface roughness of from 0.25 to 3.5 microns;
applying a layer of low dielectric loss resin to one side of the low profile copper foil sheet;
partially curing the layer of low dielectric loss resin to form a resin coated low profile copper sheet having a partially cured resin surface and a copper surface; and
laminating the resin surface of the resin coated low profile copper sheet to a resin sheet to form a laminate having a copper surface.

2. The method of claim 1, wherein the resin sheet is selected from a prepreg including a core material, and a C-staged resin containing laminate.

3. The method of claim 2, wherein the core material is woven glass.

4. The method of claim 1, wherein the layer of low dielectric loss resin is applied to the at least one side of the low profile copper foil that has a surface roughness of from 0.25 microns to 3.5 microns.

5. The method of claim 2, wherein the lamination of the resin coated low profile copper sheet to the resin sheet forms a resin gap between the core material and the low profile copper layer.

6. The method of claim 1, wherein a resin layer is located between the resin sheet and the resin coated low profile copper sheet prior to the lamination step.

7. The method of claim 6, wherein the resin layer is selected from a liquid resin layer, and a b-staged resin sheet.

8. A resin coated low profile copper sheet obtained by a method as defined in anyone of claims 1 to 7, comprising:
a layer of low profile copper; and
a layer of low dielectric loss resin.

9. The resin coated low profile copper sheet of claim 8, having a thickness of from 2 to 400 microns.

10. The resin coated low profile copper sheet of claim 8, wherein the resin layer has a thickness of from 2 to 500 microns.

11. A laminate obtained by a method as defined in anyone of claims 1 to 7, comprising:
one or more resin sheets as defined in the method of anyone of claims 1 to 7; and
at least one resin coated low profile copper sheet as defined in the method of anyone of claims 1 to 7, wherein the at least one resin coated low profile copper sheet is laminated together with the one or more resin sheets,
wherein the resin coated low profile copper sheet further comprises a layer of low profile copper having at least one side with a roughness of from 0.5 to 3.5 microns and a layer of low dielectric loss resin applied to the at least one side of the low profile copper sheet having a roughness of from 0.5 to 3.5 microns.

12. The laminate of claim 11, wherein a resin gap divides the core material from the low profile copper layer.

13. The laminate of claim 11, including a resin layer is located between the resin sheet and the resin coated low profile copper sheet.

14. A printed circuit board including at least one laminate of claim 11.

## Patentansprüche

1. Verfahren zur Herstellung eines Laminats zur Verwendung in der Herstellung von Leiterplatten, wobei das Verfahren umfasst:
Bereitstellen einer Bahn von Kupferfolie mit niedrigem Profil, die eine erste Seite und eine zweite Seite aufweist, wobei mindestens eine Seite der Kupferfolie mit niedrigem Profil eine Oberflächenrauheit von 0,25 bis 3,5 µm aufweist;
Aufbringen einer Schicht von Harz mit geringem Dielektrizitätsverlust auf einer Seite der Kupferfolienbahn mit niedrigem Profil;
teilweise Aushärten der Schicht des Harzes mit geringem Dielektrizitätsverlust, um eine harzbeschichtete Kupferbahn mit niedrigem Profil zu bilden, die eine teilweise ausgehärtete Harzoberfläche und eine Kupferoberfläche aufweist; und
Laminieren der Harzoberfläche der harzbeschichteten Kupferbahn mit niedrigem Profil auf eine Harzbahn, um ein Laminat mit einer Kupferoberfläche zu bilden.

2. Verfahren nach Anspruch 1, wobei die Harzbahn aus einem Prepreg, das ein Kernmaterial enthält, und einem Laminat, das Harz im C-Zustand enthält, ausgewählt ist.

3. Verfahren nach Anspruch 2, wobei das Kernmaterial Glasgewebe ist.

4. Verfahren nach Anspruch 1, wobei die Schicht von Harz mit geringem Dielektrizitätsverlust auf die mindestens eine Seite der Kupferfolie mit niedrigem Profil, die eine Oberflächenrauheit von 0,25 µm bis 3,5 µm aufweist, aufgetragen wird.

5. Verfahren nach Anspruch 2, wobei das Laminieren der harzbeschichteten Kupferbahn mit niedrigem Profil auf die Harzbahn eine Harzlücke zwischen dem Kernmaterial und der Kupferschicht mit niedrigem Profil bildet.

6. Verfahren nach Anspruch 1, wobei sich eine Harzschicht zwischen der Harzbahn und der harzbeschichteten Kupferbahn mit niedrigem Profil vor dem Laminierungsschritt befindet.

7. Verfahren nach Anspruch 6, wobei die Harzschicht aus einer flüssigen Harzschicht und einer Bahn mit Harz im b-Zustand ausgewählt ist.

8. Harzbeschichtete Kupferbahn mit niedrigem Profil, erhalten durch ein Verfahren nach einem der Ansprüche 1 bis 7, umfassend:
eine Schicht von Kupfer mit niedrigem Profil; und
eine Schicht von Harz mit geringem Dielektrizitätsverlust.

9. Harzbeschichtete Kupferbahn mit niedrigem Profil nach Anspruch 8, die eine Dicke von 2 bis 400 µm aufweist.

10. Harzbeschichtete Kupferbahn mit niedrigem Profil nach Anspruch 8, wobei die Harzschicht eine Dicke von 2 bis 500 µm aufweist.

11. Laminat, erhalten durch ein Verfahren nach einem der Ansprüche 1 bis 7, umfassend:
eine oder mehrere Harzbahnen, wie in dem Verfahren nach einem der Ansprüche 1 bis 7 definiert; und
mindestens eine harzbeschichtete Kupferbahn mit niedrigem Profil, wie in dem Verfahren nach einem der Ansprüche 1 bis 7 definiert, wobei die mindestens eine harzbeschichtete Kupferbahn mit niedrigem Profil zusammen mit der einen oder mehreren Harzbahnen laminiert ist,
wobei die harzbeschichtete Kupferbahn mit niedrigem Profil weiter eine Schicht von Kupfer mit niedrigem Profil, die mindestens eine Seite mit einer Rauheit von 0,5 bis 3,5 µm aufweist, und eine Schicht von Harz mit geringem Dielektrizitätsverlust umfasst, die auf der mindestens einen Seite der Kupferbahn mit niedrigem Profil, die eine Rauheit von 0,5 bis 3,5 µm aufweist, aufgetragen ist.

12. Laminat nach Anspruch 11, wobei eine Harzlücke das Kernmaterial von der Kupferschicht mit niedrigem Profil trennt.

13. Laminat nach Anspruch 11, das eine Harzschicht enthält, die sich zwischen der Harzbahn und der harzbeschichteten Kupferbahn mit niedrigem Profil befindet.

14. Leiterplatte, die mindestens ein Laminat nach Anspruch 11 enthält.

## Revendications

1. Procédé de préparation d'un stratifié à utiliser dans la fabrication de cartes de circuit imprimé, le procédé comprenant:
fournir une feuille d'une pellicule de cuivre de bas profil présentant un premier côté et un deuxième coté, dans laquelle au moins un côté de ladite pellicule de cuivre de bas profil a une rugosité superficielle allant de 0,25 à 3,5 microns;
appliquer une couche de résine de basse perte diélectrique à un côté de la feuille de pellicule de cuivre de bas profil;
durcir partiellement la couche de résine de basse perte diélectrique pour former une feuille de cuivre de bas profil revêtue de résine présentant une surface de résine partiellement durcie et une surface de cuivre; et
stratifier la surface de résine de la feuille de cuivre de bas profil revêtue de résine à une feuille de résine pour former un stratifié présentant une surface de cuivre.

2. Procédé selon la revendication 1, dans lequel la feuille de résine est sélectionnée parmi un pré-imprégné comprenant un matériau de coeur et un stratifié contenant une résine au stade C.

3. Procédé selon la revendication 2, dans lequel le matériau de coeur est un tissu de verre.

4. Procédé selon la revendication 1, dans lequel la couche de résine de basse perte diélectrique est appliquée sur l'au moins un côté de la pellicule de cuivre de bas profil qui présente une rugosité superficielle allant de 0,25 microns à 3,5 microns.

5. Procédé selon la revendication 2, dans lequel la stratification de la feuille de cuivre de bas profil revêtue de résine à la feuille de résine forme un espace de résine entre le matériau de coeur et la couche de cuivre de bas profil.

6. Procédé selon la revendication 1, dans lequel une couche de résine est située entre la feuille de résine et la feuille de cuivre de bas profil revêtue de résine avant l'étape de stratification.

7. Procédé selon la revendication 6, dans lequel la couche de résine est sélectionnée parmi une couche de résine liquide et une feuille de résine au stade b.

8. Feuille de cuivre de bas profil revêtue de résine obtenue par un procédé tel que défini à l'une quelconque des revendications 1 à 7, comprenant :
une couche de cuivre de bas profil ; et
une couche de résine de basse perte diélectrique.

9. Feuille de cuivre de bas profil revêtue de résine selon la revendication 8, présentant une épaisseur allant de 2 à 400 microns.

10. Feuille de cuivre de bas profil revêtue de résine selon la revendication 8, dans laquelle la couche de résine a une épaisseur allant de 2 à 500 microns.

11. Stratifié obtenu par un procédé tel que défini à l'une quelconque des revendications 1 à 7, comprenant:
une ou plusieurs feuilles de résine telle que définie dans le procédé selon l'une quelconque des revendications 1 à 7; et
au moins une feuille de cuivre de bas profil revêtue de cuivre telle que définie dans le procédé selon l'une quelconque des revendications 1 à 7, dans lequel l'au moins une feuille de cuivre de bas profil revêtue de résine est stratifiée avec l'une ou plusieurs feuilles de résine,
dans lequel la feuille de cuivre de bas profil revêtue de résine comprend en outre une couche de cuivre de bas profil présentant au moins un côté avec une rugosité allant de 0,5 à 3,5 microns et une couche de résine de basse perte diélectrique appliquée au au moins un côté de la feuille de cuivre de bas profil présentant une rugosité allant de 0,5 à 3,5 microns.

12. Stratifié selon la revendication 11, dans lequel un espace de résine divise le matériau de coeur de la couche de cuivre de bas profil.

13. Stratifié selon la revendication 11, comprenant une couche de résine située entre la feuille de résine et la feuille de cuivre de bas profil revêtue de résine.

14. Carte de circuit imprimé comprenant au moins un stratifié selon la revendication 11.
